(19) Europäisches Patentamt / European Patent Office / Office européen des brevets

(11) **EP 4 159 816 A1**

(12) **EUROPEAN PATENT APPLICATION**
published in accordance with Art. 153(4) EPC


(43) Date of publication:
**05.04.2023 Bulletin 2023/14**

(21) Application number: **21812236.4**

(22) Date of filing: **25.05.2021**

(51) International Patent Classification (IPC):
***C08L 101/00*** *(2006.01)* ***C08L 63/00*** *(2006.01)*
***C08K 3/00*** *(2006.01)* ***C08K 3/04*** *(2006.01)*
***C08K 3/34*** *(2006.01)* ***H05K 9/00*** *(2006.01)*

(52) Cooperative Patent Classification (CPC):
**C08K 3/00; C08K 3/04; C08K 3/34; C08L 63/00; C08L 101/00; H05K 9/00**

(86) International application number:
**PCT/JP2021/019714**

(87) International publication number:
**WO 2021/241541 (02.12.2021 Gazette 2021/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **29.05.2020 JP 2020094922**



(71) Applicant: **Kyocera Corporation**
**Kyoto-shi Kyoto 612-8501 (JP)**

(72) Inventors:
- **UCHIDA, Ken**
  **Kyoto-shi, Kyoto 612-8501 (JP)**
- **TSURUMI, Hirokazu**
  **Kyoto-shi, Kyoto 612-8501 (JP)**

(74) Representative: **Viering, Jentschura & Partner mbB**
**Patent- und Rechtsanwälte**
**Am Brauhaus 8**
**01099 Dresden (DE)**


(54) **RESIN COMPOSITION AND ELECTRONIC COMPONENT**


(57) Provided is a resin composition, a molded body of which is an electromagnetic wave absorber. An imaginary part (ε") of a complex dielectric constant at 25°C and 10 GHz and a volume resistivity (ρv) at 25°C of the molded body satisfy the relational expression (1) below, and the imaginary part (ε") is greater than

$$1.25.\ 20 < (\log\rho v) \times \varepsilon'' < 600\ (1) \qquad (1)$$


EP 4 159 816 A1

## Description

TECHNICAL FIELD

The present disclosure relates to a resin composition having a function of absorbing electromagnetic waves and to an electronic component.

BACKGROUND OF INVENTION

In recent years, electronic devices have required the ability to operate at higher speeds, and thus, the operating frequencies of integrated circuits (IC) such as memory, central processing units (CPU), power management integrated circuits (PMIC), and Bluetooth (trade name) modules have been rapidly increased. However, high frequency electromagnetic noise is also emitted from these ICs. In the telecommunications field, the demand for transmitting large volumes of information at high speeds is becoming increasingly more intense day by day, and to meet that demand, both the operating frequency and carrier frequency are required to be increased.

On the other hand, electromagnetic wave interference is required to be reduced in order to ensure the transmission reliability of communication devices. A known technique for suppressing electromagnetic noise includes an electromagnetic wave-shielding material provided with a shield layer made of metal. For example, Patent Literature 1 proposes an electromagnetic wave-shielding material produced by dispersing, in a matrix of rubber or plastic, a soft magnetic metal powder such as a powder of a metal selected from the group consisting of Fe, Ni, Co, and V or an alloy made from two or more selected from the group consisting of these metals, and forming the dispersion into a sheet shape. Patent Literature 2 proposes a sheet-shaped radio wave absorber in which a radio wave-absorbing layer is laminated on a surface of a metal body. The radio wave-absorbing layer is formed from a radio wave-absorbing material produced by dispersing a silicon carbide powder in a matrix resin. Patent Literature 3 proposes an electromagnetic wave-absorbing sheet that absorbs electromagnetic waves in a frequency band of from 5 to 7 GHz and includes a dielectric layer made from a matrix containing a carbon material, a divided electrically conductive film layer laminated on one surface of the dielectric layer, and an electromagnetic wave-reflecting layer laminated on the other surface of the dielectric layer.

CITATION LIST

PATENT LITERATURE

Patent Literature 1: JP 2001-68889 A
Patent Literature 2: JP 2005-57093 A
Patent Literature 3: JP 2012-209515 A

SUMMARY

The present disclosure has been completed based on such a finding.

That is, the present disclosure relates to the following.

[1] The resin composition of the present disclosure is such that a molded body of the resin composition is an electromagnetic wave absorber, an imaginary part (ε") of a complex dielectric constant of the molded body at 25°C and 10 GHz and a volume resistivity (ρv) at 25°C of the molded body satisfy a relational expression (1) below, and the imaginary part (ε") is greater than 1.25.

$$20 < (\log\rho v) \times \varepsilon'' < 600 \quad (1)$$

[2] An electronic component of the present disclosure includes a molded body of the resin composition described in [1] above.

BRIEF DESCRIPTION OF THE DRAWINGS

FIG. 1 is a cross-sectional view illustrating an electronic component according to an embodiment of the present

disclosure.

DESCRIPTION OF EMBODIMENTS

Among electromagnetic wave absorbers, an electromagnetic wave absorber that uses a magnetic body exhibits a decrease in the complex magnetic permeability in a high frequency band on the GHz order of from 5 GHz to 100 GHz, and the effect of suppressing electromagnetic noise is not sufficient. So-called self-poisoning is inevitable in electromagnetic wave absorbers that use reflection through metal.

However, a resin composition of the present disclosure can be used to produce a molded body exhibiting excellent electromagnetic wave-absorption performance in a high frequency band.

Hereinafter, the present disclosure will be described in detail with reference to an embodiment.

With the resin composition according to the present disclosure, a molded body of the resin composition is an electromagnetic wave absorber, and an imaginary part (ε") of a complex dielectric constant of the molded body at 25°C and 10 GHz and a volume resistivity (ρv) at 25°C of the molded body satisfy a relational expression (1) below. The imaginary part (ε') is greater than 1.25.

$$20 < (\log \rho v) \times \varepsilon'' < 600 \quad (1)$$

When high-frequency electromagnetic waves are to be absorbed through a dielectric loss of the molded body, the imaginary part (ε") of the complex dielectric constant of the molded body is required to be increased. The ε" corresponds to a resistance component with regards to an alternating current. With a material having a large ε", the resistance with regards to a direct current is generally small. The molded body also requires electrical insulation performance, and thus the resistance of the molded body with regards to the direct current is required to be increased. The present inventors discovered that the DC resistance of the molded body can be increased and the electromagnetic wave-absorption performance at a high frequency band can be enhanced by setting the imaginary part (ε") of the complex dielectric constant of the molded body at 25°C and 10 GHz and the volume resistivity (ρv) at 25°C to values satisfying the relational expression (1).

The product of the imaginary part (ε") of the complex dielectric constant of the molded body and the logarithm of the volume resistivity (ρv) is greater than 20. When the product of ε" and the logarithm of ρv is greater than 20, the electromagnetic wave-absorption performance or electrical insulation property at a high frequency band is sufficient. From such a perspective, depending on the application, the product of the ε" and the logarithm of ρv may be equal to or greater than 30, may be equal to or greater than 40, or may be equal to or greater than 45. The upper limit of the product of the ε" and the logarithm of ρv is not particularly provided, but is determined by the upper limit values of ε" and ρv. The upper limit of the product of the ε" and the logarithm of ρv may be less than 600. When the product of the ε" and the logarithm of ρv is equal to or greater than 600, an increase in signal loss becomes a concern. Thus, from such a perspective, the product of the ε" and the logarithm of ρv may be equal to or less than 300, may be equal to or less than 100, or may be equal to or less than 80.

The ε" is greater than 1.25. When the ε" is equal to or less than 1.25, a decrease in the electromagnetic wave-absorption capacity of the molded product in the high frequency band becomes a concern. From such a perspective, the ε" may be equal to or greater than 3, may be equal to or greater than 4, may be equal to or greater than 5, or may be equal to or greater than 6. On the other hand, the upper limit of the ε" may be less than 40, or may be equal to or less than 3 5.

From the perspective of reducing signal loss, a real part (ε') of the complex dielectric constant at 25°C and 10 GHz of the molded body may be less than 40, may be less than 30, or may be less than 25. The lower limit of the ε' is not particularly set, but may be greater than 1.25.

Note that the ε' and the ε" can be measured in accordance with a waveguide method, and specifically, the ε' and the ε" can be measured by the method described in the examples.

From the perspective or reducing electromagnetic wave signal loss, a dielectric loss tangent (tanδ) of the molded body at 25°C and 10 GHz may be from 0.1 to 0.8, or from 0.2 to 0.75.

From the perspective of electrical insulation performance, the volume resistivity (ρv) of the molded body at 25°C may be equal to or greater than $1.0 \times 10^6$ Qcm, or may be equal to or greater than $1.0 \times 10^7$ Qcm. The upper limit is not particularly provided, but may be equal to or less than $1.0 \times 10^{16}$ Ωcm.

Note that the ρv can be measured in accordance with JIS K-6911:2006, and specifically, the ρv can be measured by the method described in the examples.

The molded body may have a low specific gravity in consideration of application in a portable device or vehicle requiring a reduction in weight. The specific gravity of the molded body may be from 1.2 to 3.2, or may be from 1.5 to 3.0.

Note that the specific gravity of the molded body can be determined by measuring the mass and buoyancy of

a cured material in air and in water using a balance. Specifically, the specific gravity can be measured by the method described in the examples.

Some electronic components for communications generate a significant amount of heat, and thus the combined use of a heat-dissipating mechanism such as a heat-dissipating sheet is generally required. In particular, a higher level of heat dissipation performance is necessary to support future applications in the high frequency band. Increasing the coefficient of thermal conductivity of the molded body and imparting heat dissipation performance to an electromagnetic wave-absorbing material is extremely useful because doing so eliminates the required combined use of another mechanism such as a heat-dissipating sheet, and enables a reduction in the size and weight of electronic components and a reduction in the man-hours required for assembly. From such a perspective, the coefficient of thermal conductivity of the molded body may be from 0.5 W/m·K to 6.0 W/m·K, or may be from 0.6 W/m·K to 5.0 W/m·K.

Note that the coefficient of thermal conductivity of the molded body can be determined by a method such as a hot wire method or a laser flash method. In the hot wire method, a temperature gradient when heat flow energy is applied by a hot wire is compared with a sample for which the coefficient of thermal conductivity is known. In the laser flash method, a high energy level is instantaneously imparted by a laser or the like to a homogeneous substance, and the coefficient of thermal conductivity is calculated on the basis of the specific heat and thermal diffusivity measured at that time. Specifically, the coefficient of thermal conductivity can be measured by the method described in the examples.

Electronic components for communication are becoming smaller in size and lighter in weight, and thus electromagnetic wave-absorbing materials are required to be thin. For example, a package of a module-type electronic component may be asymmetrical and thin with a large surface area. In a packaging process as typified by fan-out wafer-level packaging (FOWLP), electronic components on a large base material are collectively sealed on one side and then separated into individual components. Such a packaging process requires warpage to be reduced.

A useful solution includes bringing the thermal expansion of the molded body as close as possible to that of an insert having a low thermal expansion coefficient, or in other words, reducing the thermal expansion of the molded body. From such a perspective, the thermal expansion rate ($\alpha$1: thermal expansion coefficient between ambient temperature (25°C) and the glass transition temperature) of the molded body may be 1 ppm/deg. or higher, or may be 3 ppm/deg. or higher. The thermal expansion rate of the molded body may also be equal to or less than 40 ppm/deg., or may be equal to or less than 35 ppm/deg.. When the molded body is used as a sealing material, the thermal expansion rate of the molded body may be equal to or less than 18 ppm/deg, or may be equal to or less than 15 ppm/deg.

Note that the thermal expansion coefficient of the molded body can be determined from the slope of the tangent between 25°C and 60°C in a TMA chart obtained by measurements through thermal mechanical analysis (TMA), and specifically, the thermal expansion coefficient can be measured by the method described in the examples.

The resin composition of the present disclosure is not particularly limited as long as the resulting molded body satisfies the relational expression (1) described above, and the resin composition may include (A) at least one resin selected from the group consisting of thermosetting resins and thermoplastic resins, (B) an inorganic filler (excluding the following component (C)), and (C) a carbon material.

(A) Resin

The resin of the component (A) is at least one type selected from the group consisting of thermosetting resins and thermoplastic resins. Examples of the thermosetting resins include epoxy resins, phenolic resins, and imide resins. Examples of the thermoplastic resins include polyamide and polycarbonate. From the perspective of viscosity in precision component molding, the resin of the component (A) may be a thermosetting resin. From the perspectives of electrical insulation and heat resistance, the resin of the component (A) may be an epoxy resin, or may be an imide resin.

A single type of resin may be used as the resin of the component (A), or two or more types may be combined and used.

The imaginary part ($\varepsilon$") of the complex dielectric constant at 25°C and 10 GHz of the resin of the component (A) may be high. When the $\varepsilon$" of the resin of the component (A) is high, the molded body easily satisfies the relational expression (1). The $\varepsilon$" of the molded body at 25°C and 10 GHz can be set to greater than 1.25. The $\varepsilon$" of the resin of the component (A) may be from 0.04 to 2.0, from 0.05 to 2.0, or from 0.1 to 1.0. The real part ($\varepsilon$') of the complex dielectric constant at 25°C and 10 GHz of the resin of the component (A) may be low. When $\varepsilon$' of the resin of the component (A) is low, $\varepsilon$' of the molded body at 25°C and 10 GHz can be set to less than 40. The $\varepsilon$' of the resin of the component (A) may be from 2.0 to 5.0.

Note that $\varepsilon$' and $\varepsilon$" of the resin of the component (A) are values measured by the waveguide method after a test piece plate is molded together with a curing agent, and specifically, are values measured by the method described in the examples.

The epoxy resin has two or more epoxy groups per molecule, and the molecular structure, molecular weight, and the like are not particularly limited as long as the epoxy resin is one that is commonly used in electronic components.

Examples of the epoxy resin include aliphatic epoxy resins, such as phenol novolac-type epoxy resins, cresol

novolac-type epoxy resins, and dicyclopentadiene derivatives; and aromatic epoxy resins, such as biphenyl-type, biphenyl aralkyl-type, naphthyl-type, and bisphenol-type epoxy resins. A single type of these epoxy resins may be used, or two or more may be mixed and used. The properties of the epoxy resin are also not particularly limited, and the epoxy resin may be either a liquid or a solid at ambient temperature (25°C). For example, the epoxy resin may be a liquid bisphenol-type epoxy resin, and specifically, may be a bisphenol A-type or a bisphenol F-type epoxy resin. The liquid bisphenol-type epoxy resin may be a liquid bisphenol A-type epoxy resin. The liquid bisphenol A-type epoxy resin is commercially available, such as, for example, EPOMIK (trade name) R140 (available from Mitsui Chemicals, Inc.).

Note that in the present disclosure, the liquid bisphenol type epoxy resin refers to a bisphenol type epoxy resin that is in a liquid form at 25°C.

The epoxy equivalent weight of the epoxy resin may be equal to or greater than 140 from the perspective of thermal mechanical properties. From the perspective of electromagnetic wave-absorption performance, the epoxy equivalent weight may be equal to or greater than 200, or may equal to or greater than 250. The upper limit value of the epoxy equivalent weight may be equal to or less than 400, may be equal to or less than 380 from the perspective of thermal mechanical properties.

The epoxy resin may include a polyoxyalkylene structure represented by ($R^1$O)m and a polyoxyalkylene structure represented by ($R^2$O)n. The resin composition of the present disclosure includes an epoxy resin with a polyoxyalkylene structure, and thereby the resulting molded body easily satisfies the relational expression (1).

Here, $R^1$ and $R^2$ each independently represent an alkylene group having one or more carbons. m + n may be from 1 to 50, or may be from 1 to 20. m may be from 0 to 49, or may be from 0 to 19. n may be from 1 to 50, or may be from 1 to 20.

Examples of the alkylene groups represented by $R^1$ and $R^2$ include a C1-6 alkylene group, and specifically include a methylene group, an ethylene group, a trimethylene group, a propylene group, a tetramethylene group, and a hexamethylene group. From the perspective of electromagnetic wave-absorption performance, each of the alkylene groups may be a methylene group or an ethylene group.

Of the quantity m of the $R^1$O groups, the plurality of $R^1$ may all be the same alkylene group, or may be alkylene groups with different numbers of carbons. Of the quantity n of the $R^2$O groups, the plurality of $R^2$ may all be the same alkylene group, or may be alkylene groups with different numbers of carbons.

Examples of the epoxy resin including the polyoxyalkylene structure include liquid epoxy resins including a bisphenol A skeleton, and polyethylene glycol diglycidyl ether. An example of a commercially available product of the liquid epoxy resin including the bisphenol A skeleton includes Rikaresin BEO-60E (available from New Japan Chemical Co., Ltd.) expressed by the following general formula (1). An example of a commercially available product of the polyethylene glycol diglycidyl ether includes Epolite 400E (available from Kyoeisha Chemical Co., Ltd.), which contains a compound represented by the following general formula (2) as a main constituent.

[Chem. 1]

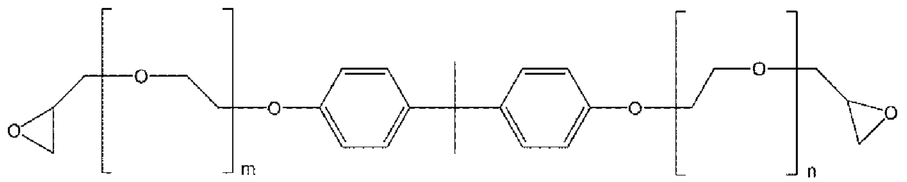

(1)

m+n=6

[Chem. 2]

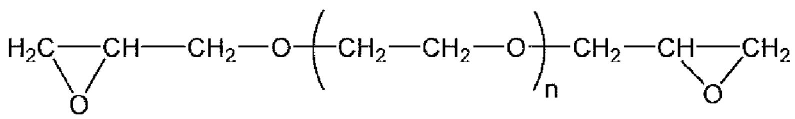

(2)

n≒9

An example of the imide resin includes bis-allyl nadi-imide. Bis-allyl nadi-imide can be procured as a commercially available product, including, for example, BANI-M (available from Maruzen Petrochemical Co., Ltd.) and BANI-X (available from Maruzen Petrochemical Co., Ltd.).

The content of the resin of the component (A) in relation to the total amount of the resin composition of the present disclosure may be from 6 mass% to 40 mass%, may be from 10 mass% to 40 mass%, may be from 20 mass%

to 38 mass%, or may be from 25 mass% to 30 mass%. When the content of the resin of the component (A) is equal to or greater than 10 mass%, suitable thermal mechanical properties are obtained, and when the content thereof is equal to or less than 40 mass%, appropriate fluidity can be maintained.

When the resin of the component (A) includes a thermosetting resin, the resin composition of the present disclosure may further contain a curing agent and a curing accelerator.

Examples of the curing agent include aliphatic amines, aromatic amines, dicyandiamides, dihydrazide compounds, acid anhydrides, and phenol resins. One type of these curing agents may be used, or two or more types may be used in combination.

Examples of the curing accelerator include organic peroxides, such as dicumyl peroxide and dibutyl peroxide; and imidazole compounds, such as 2-methylimidazole and 2-ethylimidazole. One type of these curing accelerators may be used, or two or more types may be used in combination.

When the resin composition of the present disclosure contains a curing agent, the content of the curing agent relative to the total amount of the resin composition may be from 1.0 mass% to 20.0 mass%, may be from 2.0 mass% to 18.0 mass%, or may be from 3.0 mass% to 15.0 mass%. When the resin composition of the present disclosure contains a curing accelerator, the content of the curing accelerator relative to the total amount of the resin composition may be from 0.1 mass% to 10.0 mass%, may be from 0.2 mass% to 8.0 mass%, or may be from 0.5 mass% to 6.0 mass%.

(B) Inorganic filler

The inorganic filler (excluding the component (C) described below) of the component (B) is not particularly limited as long as the inorganic filler is one that is used in an electronic component, and the inorganic filler may be one having a high dielectric constant and a high dielectric loss tangent. Examples of the inorganic filler include silica, alumina, titanium oxide, barium titanate, silicon nitride, aluminum nitride, and silicon carbide. One type of these inorganic fillers may be used, or two or more types may be used in combination. From the perspective of improving electromagnetic wave-absorption performance in a high frequency band of a resulting molded body, the component (B) may be at least one type selected from the group consisting of silica, alumina, and silicon carbide, or may be silicon carbide.

The inorganic filler of the component (B) may have high resistance and a high imaginary part (ε") of the complex dielectric constant at 25°C and 10 GHz. When ε" of the inorganic filler of the component (B) is high, the molded body easily satisfies the relational expression (1). The ε" of the molded body at 25°C and 10 GHz can be set to greater than 1.25. The ε" of the inorganic filler of the component (B) may be from 0.1 to 30.0, may be from 1.0 to 30.0, may be from 1.5 to 20.0, or may be from 2.0 to 20.0.

Note that the ε" of the inorganic filler of the component (B) is a value measured by the waveguide method after firing of the test piece plate, and specifically, is a value measured by the method described in the examples.

The shape of the inorganic filler of the component (B) is not particularly limited, and examples of the shape thereof include powdery, spherical, and fibrous. The shape of the inorganic filler of the component (B) may be powdery, or may be spherical.

The average particle size of the inorganic filler of the component (B) is not particularly limited, but may be from 0.1 μm to 100 μm, from 0.2 μm to 75 μm, or from 0.2 μm to 50 μm. In consideration of application to a thin-walled molding material, the maximum particle size of the inorganic filler of the component (B) may be equal to or less than 150 μm or may be equal to or less than 100 μm or less. When the average particle size of the inorganic filler of the component (B) is equal to or greater than 0.1 μm, appropriate fluidity can be maintained. When the average particle size is equal to or less than 100 μm, molding defects such as non-filling can be reduced.

Note that in the present specification, the average particle size is the volume average particle size, and the average particle size of the inorganic filler of the component (B) can be calculated as an average value of the long diameter of the particles, measured using a laser diffraction-type device for measuring the particle size distribution.

When silicon carbide is contained in the inorganic filler of the component (B), the content of silicon carbide in relation to the total inorganic filler may be equal to or greater than 10 mass%, may be equal to or greater than 50 mass%, may be equal to or greater than 70 mass%, or may be equal to or greater than 100 mass% or more, from the perspective of improving electromagnetic wave-absorption performance in the high frequency band of the resulting molded body.

The content of the inorganic filler of the component (B) in relation to the total amount of the resin composition of the present disclosure may be from 30 mass% to 92 mass%, from 35 mass% to 90 mass%, or from 40 mass% to 88 mass%. When the content of the inorganic filler of the component (B) is equal to or greater than 30 mass%, electromagnetic wave-absorption performance in the high frequency band of the obtained molded body can be improved. When the content of the inorganic filler of the component (B) is equal to or less than 92 mass%, appropriate fluidity can be obtained.

(C) Carbon material

The carbon material of the component (C) is not particularly limited as long as it is a carbon material used in

electronic components, and is only required to be a carbon material that can increase the dielectric constant and loss dielectric constant of the resulting molded body. When such a carbon material is adopted, the resulting molded body exhibits excellent electromagnetic wave-absorption performance in the high frequency band. The molded body easily satisfies the relational expression (1). Examples of the carbon material of the component (C) include carbon black, carbon nanotubes, fullerenes, graphite, graphene, and derivatives thereof. One type of these carbon materials may be used, or two or more types may be used in combination. The carbon material of the component (C) may be at least one type selected from the group consisting of carbon black, carbon nanotubes, and graphene, or may be at least one type selected from the group consisting of carbon nanotubes and graphene.

From the perspective of maintaining dispersibility, the average fiber length of the carbon nanotubes may be equal to or less than 100 μm, or may be equal to or less than 50 μm. From the perspective of electromagnetic wave-absorption performance, the lower limit value of the average fiber length may be 0.005 μm, 0.010 μm, or 0.10 μm.

From the perspective of insulation properties, the average fiber diameter of the carbon nanotubes may be from 1 nm to 30 nm, or from 5 nm to 25 nm.

From the perspective of electromagnetic wave-absorption capability, the carbon nanotubes may have an aspect ratio (ratio of the fiber length to the fiber diameter) of from 500 to 10000, or from 1000 to 5000.

Note that the average fiber length and the average fiber diameter of the carbon nanotubes can be determined by randomly selecting 100 samples of carbon nanotubes using a scanning electron microscope (SEM), measuring the fiber length and the fiber diameter of each sample, and calculating the number average of both the fiber length and the fiber diameter. The aspect ratio of the carbon nanotubes can be determined through calculations from the average fiber length and the average fiber diameter value calculated as described above.

The carbon nanotubes can be produced by a method such as chemical vapor deposition (CVD) and an arc discharging method.

The carbon nanotubes may have a single layer structure or a multilayer structure, and from the perspectives of price and procurement ease, the carbon nanotubes may have a multilayer structure.

Examples of the carbon black include furnace black, channel black, thermal black, acetylene black, and ketjen black.

The average particle size of the carbon black is not particularly limited, but may be from 1 nm to 80 nm, or from 5 nm to 60 nm.

Note that the average particle size of the carbon black can be determined by randomly selecting 100 particles, measuring the diameter of the particles using a transmission electron microscope (TEM), and calculating the average value thereof.

The graphene may be highly dispersible in the matrix resin, or may be a graphene oxide including an organic group.

The specific surface area of the graphene may be from 10 $m^2/g$ to 3000 $m^2/g$, from 20 $m^2/g$ to 1500 $m^2/g$, or from 500 $m^2/g$ to 500 $m^2/g$.

The specific surface area is a value measured by a BET single point method through nitrogen adsorption.

Note that in the present specification, "graphene" means a "sheet-like substance of sp2-bonded carbon atoms of 10 or fewer layers".

The graphene ordinarily exhibits dispersibility in water and specific polar solvents. The graphene may be already highly dispersed in a solvent, and a below-described dispersion aid may be used in combination. Examples of the solvent include water and organic solvents such as acetone, methyl isobutyl ketone, isopropyl alcohol, and tetrahydrofuran.

The concentration of graphene in the dispersion is not particularly limited, but may be from 0.01 mass% to 10 mass%, or from 0.1 mass% to 5 mass%.

The average particle size of the fullerenes, graphite, and derivatives of these is not particularly limited, but may be from 1 nm to 10000 nm, or may be from 10 nm to 1000 nm. The average particle size can be determined by randomly selecting 100 particles, measuring the diameter of the particles using a transmission electron microscope (TEM), and calculating the average value thereof.

When the carbon material of the component (C) includes carbon nanotubes, the content of the carbon nanotubes in relation to the total amount of the resin composition may be equal to or less than 3.0 mass%, or may be equal to or less than 1.0 mass%. When the content of the carbon nanotubes is equal to or less than 3.0 mass%, the electrical insulation property of the resin composition can be maintained.

The content of the carbon material of the component (C) in relation to the total amount of the resin composition of the present disclosure may be from 0.1 mass% to 20 mass%, from 0.2 mass% to 15 mass%, or from 0.3 mass% to 10 mass%. When the content of the carbon material of the component (C) is equal to or greater than 0.1 mass%, electromagnetic wave-absorption performance in the high frequency band of the resulting molded body can be improved. When the content of the carbon material of the component (C) is equal to or less than 20 mass%, electrical insulation properties of the resulting molded body can be maintained.

(D) Dispersion aid

The resin composition of the present disclosure may further include a dispersion aid (D). The dispersion aid of the component (D) may be any material that stably and highly disperses fine particles in a matrix resin, and generally, coupling agents and surfactants having functional groups with different reactivity in a single molecule are used. Examples of the dispersion aid of the component (D) include surfactants, such as anionic surfactants such as carboxylates, and cationic surfactants such as quaternary ammonium salts; coupling agents having an amine-based functional group and a sulfide-based functional group, and cellulose nanofibers. The dispersion aid of the component (D) may be a coupling agent having an amine-based functional group and a sulfide-based functional group, or may be cellulose nanofibers.
The cellulose nanofibers are bipolar micro-solids and improve the dispersibility of a filler through a surface-active action. The cellulose nanofibers may be already highly dispersed in a liquid such as water or a thermosetting resin oligomer.
From the perspectives of workability and fluidity, the average fiber length of the cellulose nanofibers may be from 1 $\mu$m to 100 $\mu$m, or from 5 $\mu$m to 50 $\mu$m.
The average fiber diameter of the cellulose nanofibers, including aggregates, may be from 1 nm to 1000 nm, or from 4 nm to 500 nm. When the average fiber diameter is within the range described above, the dispersibility of the component (C) is increased, and the dielectric constant can be reduced.
Note that the average fiber length and the average fiber diameter of the cellulose nanofibers can be measured using a scanning electron microscope (SEM) through the same operation used to obtain the average fiber length and average fiber diameter of the carbon nanotubes described above.
Examples of commercially available products of the coupling agent having an amine-based functional group and a sulfide-based functional group include SUMILINK (trade name) 100 (available from Sumitomo Chemical Co., Ltd.). Examples of commercially available products of the cellulose nanofibers include ELLEX-S (available from Oji Paper Co., Ltd.).
When the resin composition of the present disclosure includes the dispersion aid of the component (D), from the perspective of maintaining dispersibility and thermal mechanical properties, the content of the dispersion aid in relation to the total amount of the resin composition may be from 0.1 mass% to 30 mass%, from 0.2 mass% to 10 mass%, or from 0.3 mass% to 5 mass%.

(E) Magnetic body

The resin composition of the present disclosure may or may not include a magnetic body (E). The magnetic body of the component (E) is not particularly limited as long as it is a magnetic body made of a magnetic material generally used for reducing electromagnetic waves. Examples of the magnetic material include amorphous magnetic metal alloys, Ni-Fe based alloys, pure iron, mild steel, silicon steel (Fe-Si alloys), Fe-Al alloys, Fe-Si-Al alloys, Co-Fe based alloys, carbonyl iron, and other such soft magnetic materials, and ferrites. One type of these magnetic materials may be used, or two or more types may be used in combination.
Specific examples of amorphous magnetic metal alloys include Fe-B-Si based, Fe-B-Si-C based, Fe-B-Si-Cr based, Fe-Co-B-Si based, Fe-Ni-Mo-B based, Co-Fe-Ni-Mo-B-Si based, and Co-Fe-Ni-B-Si based amorphous magnetic metal alloys. Examples of Ni-Fe based alloys include 36-permalloy, 45-permalloy, $\mu$-metal, 78-permalloy, Cr-permalloy, Mopermalloy, and supermalloy.
Specific examples of the ferrites include Mn-Zn based ferrite, Ni-Zn based ferrite, Cu-Zn based ferrite, Cu-Zn-Mg ferrite, Mn-Mg-Al ferrite, Y-type hexagonal ferrite, Z-type hexagonal ferrite, and M-type hexagonal ferrite.
The magnetic material included in the magnetic body of the component (E) may be a silicon steel, an Fe-Si-Al alloy, and a Ni-Fe based alloy, and from the perspective of the noise absorption frequency, the magnetic material may be a silicon steel.
When the resin composition of the present disclosure is used as a semiconductor sealing material, metal foreign matter is removed in the process of producing the semiconductor sealing material. When the metal foreign matter is removed using a magnet, the magnetic body of the component (E) is considered to be foreign matter and is removed, and thus the yield is poor. From such a perspective, when the resin composition of the present disclosure contains the magnetic body of the component (E), the content of the magnetic body in relation to the total amount of the resin composition may be equal to or less than 1 mass%, may be equal to or less than 0.5 mass%, or may be equal to or less than 0 mass%. Since specific gravity of the magnetic body of the component (E) is large, the content of the magnetic body of the component (E) may be equal to or less than the abovementioned values from the perspective of weight reduction of the resulting molded body.
In addition to each of the components described above, the resin composition of the present disclosure can be compounded, as necessary, with additives generally blended in this type of composition without departing from the gist of the present disclosure, examples of the additives including release agents, such as synthetic waxes, natural

waxes, higher fatty acids, and esters of higher fatty acids; colorants, such as cobalt blue; modifiers, such as silicone oil or silicone rubber; hydrotalcites; ion scavengers; and electrostatic charge-controlling agents. One type of these additives may be used, or two or more types may be mixed and used.

The content of each of these additives in the resin composition of the present disclosure in relation to the total amount of the resin composition can be set from 0.05 mass% to 5.0 mass%, and may be from 0.2 mass% to 3.0 mass%, for each additive and as a total amount of the additives.

The total content of the components (A), (B), and (C) in the resin composition of the present disclosure may be equal to or greater than 70 mass%, or may be equal to or greater than 80 mass% or greater.

The resin composition of the present disclosure is prepared by thoroughly and uniformly mixing, with a mixer or the like, the components (A) to (C) and optionally, a dispersion aid (D), a curing agent, a curing accelerator, and various additives, which are blended as necessary, and then kneading the mixture using a disperser, a kneader, a three-roll mill, a twin-screw heating roll, a twin-screw heating extrusion kneader, or the like. The kneading process may be implemented with heating. The temperature when heating may be from 70°C to 150°C or from 75°C to 120°C.

After the kneading process, the resin composition of the present disclosure may be, for example, cooled and solidified, ground to an appropriate size using a cutting mill, a ball mill, a cyclone mill, a hammer mill, a vibration mill, a cutter mill, a grinder mill, a speed mill, or the like, and then used.

The mixture obtained after the kneading process may be pressed and molded into a sheet shape in a molding machine at a temperature of from 50°C to 100°C and a pressure of from 0.5 MPa to 1.5 MPa.

The resin composition of the present disclosure can be used as an electromagnetic wave-absorbing material, an electromagnetic wave-absorbing sheet, a semiconductor sealing material, a sealing sheet, a covering material, or the like.

As an embodiment of the present disclosure, an electromagnetic wave-absorbing material can be used as a semiconductor sealing material. For example, a resin-sealed electronic component can be prepared by fixing a semiconductor element on a substrate, and sealing the fixed semiconductor element with the resin composition of the present disclosure.

Note that a known molding method can be used without particular limitation to produce an electronic component. The most common molding method is low pressure transfer molding, but the molding can also be implemented by injection molding, cast molding, compression molding, and the like.

For example, when the transfer molding method is used, a heating treatment is implemented in a molding die using a transfer molding machine at a temperature of from 150°C to 200°C for a time of from 20 seconds to 200 seconds, a molded article is removed from the molding die, and the molded article is subjected to a heating treatment at a temperature of from 150°C to 200°C for 2 hours to 12 hours to complete the curing.

When the compression molding method is used, first, a substrate on which a semiconductor element is mounted is supplied to an upper mold of a mold die, and the resin composition of the present disclosure is supplied into a cavity of a lower mold. Subsequently, the upper and lower molds are clamped at a required mold clamping force, and thereby the substrate on which the semiconductor element is mounted is immersed into the resin composition heated and melted inside the cavity of the lower mold. Afterwards, the resin composition heated and melted inside the lower mold cavity is pressed by a cavity bottom surface member, a required pressure is applied under reduced pressure, and the resin composition is compression molded. The molding conditions may include a temperature of from 120°C to 200°C and a pressure of from 2 MPa to 20 MPa.

FIG. 1 illustrates an example of an electronic component 10 of the present disclosure thus prepared, and an adhesive layer 3 may be interposed between a lead frame 1 such as a copper frame and a semiconductor element 2. An electrode 4 on the semiconductor element 2 and a lead part 5 of the lead frame 1 are connected by a bonding wire 6. These components are subjected to electromagnetic wave absorption by a molded body (sealing material) 7 of the resin composition of the present disclosure.

The type of semiconductor element sealed by the resin composition of the present disclosure is not particularly limited, but may be a semiconductor element for a smart device. When compression molding is used, the semiconductor element may be one for which the thickness of the electronic component after molding is from 0.2 mm to 1.5 mm.

In this manner, an electronic component can have excellent electromagnetic wave-absorption performance at a high frequency band by using the resin composition of the present application to absorb electromagnetic waves of the semiconductor element.

The electromagnetic wave-absorption performance of a molded body of the resin composition of the present disclosure may be equal to or less than -3 dB, may be equal to or less than -5 dB, or may be equal to or less than -10 dB.

The electromagnetic wave-absorption performance is a value obtained as follows. A molded body having a thickness of 0.5 mm and prepared through compression molding is installed between a high-frequency oscillating device and a reception antenna. The electromagnetic wave intensity when electromagnetic waves having a measurement frequency of 10 GHz are generated is measured for both a case in which the molded body is present and a case in which the molded body is not present. A ratio of the electromagnetic wave intensities of both cases ((electromagnetic

wave intensity when electromagnetic waves are absorbed by the molded body)/(electromagnetic wave intensity when the molded body is not present)) is then expressed in units of dB.

Note that the electromagnetic wave intensity can be measured in accordance with the "IEICE Transactions on Fundamentals of Electronics, Communications, and Computer Sciences B, Vol. J97-B, No. 3, pp. 279-285".

EXAMPLES

The present disclosure will be specifically described through examples; however, the present disclosure is not limited in any way to these examples.

Examples 1 to 22 and Comparative Examples 1 to 6

Each component of the type and blending amount described in Table 1-1 and Table 1-2 was inserted into a Henschel mixer and mixed, after which the mixture was inserted into a twin-screw kneader heated to 110°C, and the mixture was heated and kneaded until becoming uniform. The heated and kneaded product was inserted into a cold roll, extended into a sheet shape, and then ground, and a resin composition was produced, which is a molding material for an electromagnetic wave-absorbing material.

Details of each component used in preparing the resin compositions are described in Table 1-1, Table 1-2 and Table 2 as follows.

(A) Resin

- Epoxy resin 1: EPOMIK (trade name) R140; liquid bisphenol A type epoxy resin; available from Mitsui Chemicals, Inc., epoxy equivalent weight: 189, ε" (25°C, 10 GHz) = 0.04, ε' (25°C, 10 GHz) = 2.5
- Epoxy resin 2: Rikaresin BEO-60E; liquid epoxy resin with bisphenol A skeleton (having bisphenol A-bis(triethyleneglycol glycidyl ether)ether as a main constituent) (compound represented by general formula (1)); available from New Japan Chemical Co., Ltd., epoxy equivalent weight: 365, ε" (25°C, 10 GHz) = 0.20, ε' (25°C, 10 GHz) = 3.0
- Epoxy resin 3: Epolite 400E; polyethylene glycol diglycidyl ether (having a compound represented by general formula (2) as a main constituent); available from Kyoeisha Chemical Co., Ltd., epoxy equivalent weight: 277, ε" (25°C, 10 GHz) = 0.20, ε' (25°C, 10 GHz) = 3.0
- Imide resin 1: BANI-M; bis-allyl nadi-imide; available from Maruzen Petrochemical Co., Ltd., ε" (25°C, 10 GHz) = 0.07, ε' (25°C, 10 GHz) = 2.5

(B) Inorganic filler

- Silica: FB105FC; available from Denka Co., Ltd., average particle size: 20 μm, maximum particle size: 50 μm, ε" (25°C, 10 GHz) = 0.001
- Silicon carbide (SiC): DIASIC; available from Yakushima Denko Co., Ltd., average particle size: 5 μm, maximum particle size: 10 μm, ε" (25°C, 10 GHz) = 2.0
- Alumina: DAW07; available from Denka Co., Ltd., average particle size: 8 μm, maximum particle size: 50 μm, ε" (25°C, 10 GHz) = 0.1

Note that ε" and ε' of the resin (A) and ε" of the inorganic filler (B) were measured by the following method.

The resin (A) was added at an amount at which a curing agent 1 was equivalent to each resin, and then inserted into a mold and compression molded (temperature: 175°C, pressure: 10 MPa) into a plate, each having a thickness of 1.0 mm.

The inorganic filler (B) was inserted into each mold and fired (temperature: 1500°C, 10 hours) to form a plate having a thickness after firing of 1.0 mm.

The obtained plate was then used, measurements were implemented in a frequency range of from 8.20 GHz to 12.40 GHz at a temperature of 25°C using a network analyzer (Agilent PNA E8363B) and a rectangular waveguide (WRJ-10), and the values of ε" and ε' of the resin (A) and ε" of the inorganic filler (B) at 10 GHz were determined.

(C) Carbon material

- Carbon nanotubes (CNT): LUCAN; available from LG Chem Ltd., average fiber length: 30 μm, average fiber diameter: 0.02 μm, aspect ratio: 1500
- Carbon black (CB): CB30; available from Mitsubishi Chemical Corporation, average particle size: 50 nm
- Graphene: Graphene nanoplatelets H; available from XG Sciences, Inc., specific surface area (BET method): 30 $m^2/g$

(D) Dispersion aid

- Cellulose nanofiber: ELLEX-S; available from Daio Paper Corporation, average fiber diameter: 20 to 200 nm
- Coupling agent: SUMILINK (trade name) 100; S-(3-aminopropyl)thiosulfuric acid; available from Sumitomo Chemical Co., Ltd.

(E) Magnetic body

- Fe-Si-Cr powder: available from Nippon Atomized Metal Powders Corporation, specific gravity: 7.6, average particle diameter: 11 μm

Curing agent

- Curing agent 1: MEH7500; triphenylmethane-type phenol resin; available from Meiwa Plastic Industries, Ltd.

(C) Curing Accelerator

- Curing accelerator 1: Curezol C11Z; imidazole compound; available from Shikoku Chemicals Corporation
- Curing accelerator 2: Percumyl D; organic peroxide, available from NOF Corporation

(Evaluation)

Molded bodies, each having a thickness of 0.5 mm or 1.0 mm, were compression molded (temperature: 175°C, pressure, 10 MPa) from each of the resin compositions obtained in Examples 1 to 22 and Comparative Examples 1 to 6. The complex dielectric constant, the volume resistivity, the coefficient of thermal conductivity, and the electromagnetic wave-absorption performance were measured by the following methods. The evaluation results are shown in Table 1-1, Table 1-2 and Table 2.

(1) Complex dielectric constant (real part: ε', imaginary part: ε") and dielectric loss tangent (tanδ)

The dielectric characteristics were measured within a frequency range of from 8.20 GHz to 12.40 GHz at a temperature of 25°C using a molded body having a thickness of 1.0 mm, a network analyzer (Agilent PNA E8363B), and a rectangular waveguide (WRJ-10), and each value at 10 GHz was determined.

(2) Volume resistivity (ρv)

The volume resistivity at 150°C was measured in accordance with JIS K-6911:2006 using a molded body having a thickness of 1.0 mm.

(3) (log$\rho$v) $\times$ $\varepsilon$"

The product of $\varepsilon$" and the logarithm of $\rho$v was calculated from $\varepsilon$" measured in (1) above and $\rho$v measured in (2) above.

(4) Coefficient of thermal conductivity

One side of a molded body having a thickness of 1.0 mm was irradiated with a laser beam, and heat flow energy for which the intensity was periodically modulated was applied thereto. The phase difference in temperature response at the other side of the molded body was then detected using a temperature sensor, the thermal diffusivity and specific heat were determined, and the coefficient of thermal conductivity was calculated.

(5) Specific gravity

A disk-shaped molded body having a thickness of 2.0 mm and a diameter of 5 mm was prepared by compression molding (temperature: 180°C, pressure: 5 MPa). On the basis of a hydrostatic weighing method defined by the JIS Z 8807:2012 standard on methods for measuring density and specific gravity of a solid, the molded body was used, the mass and buoyancy of the molded body were measured in air and in water using a scale, and the specific gravity was determined.

(6) Thermal expansion coefficient ($\alpha$1)

In accordance with the TMA method, the temperature was increased from room temperature (25°C) to 300°C at a temperature increase rate of 5°C/min using a thermal analyzer (product name: SSC/5200, available from Seiko Instruments Inc.), and from the obtained TMA chart, the slope of the portion that was from 25°C to 60°C and closest to a straight line was defined as the linear expansion coefficient $\alpha$1.

(7) Electromagnetic wave-absorption performance

A molded body having a thickness of 0.5 mm was installed between a high-frequency oscillating device and a reception antenna. The electromagnetic wave intensity when electromagnetic waves having a frequency of 10 GHz were generated was measured for both a case in which the molded body was present and a case in which the molded body was not present. The ratio of the electromagnetic wave intensities of both cases ((electromagnetic wave intensity when electromagnetic waves were absorbed by the molded body)/(electromagnetic wave intensity when the molded body was not present)) was then expressed in units of dB and used as electromagnetic wave-absorption performance.
Note that the electromagnetic wave intensity was measured in accordance with the "IEICE Transactions on Fundamentals of Electronics, Communications, and Computer Sciences B, Vol. J97-B, No. 3, pp. 279-285".

[Table 1-1]

Table 1-1

| | | Examples | | | | | | | | | | |
|---|---|---|---|---|---|---|---|---|---|---|---|---|
| | | 1 | 2 | 3 | 4 | 5 | 6 | 7 | 8 | 9 | 10 | 11 |
| (A) Resin [mass%] | Epoxy resin 1 | - | - | - | - | - | 22.6 | 23.8 | - | - | 27.2 | - |
| | Epoxy resin 2 | 29.1 | - | 27 | 27 | 27 | - | - | - | 29.3 | - | 32.6 |
| | Epoxy resin 3 | - | 26.7 | - | - | - | - | - | - | - | - | - |
| | Maleimide resin 1 | - | - | - | - | - | - | - | 25.8 | - | - | - |
| (B) Inorganic filler [mass%] | Silica | - | - | - | - | - | - | 11.9 | - | - | 45.3 | 45.3 |
| | SiC | 59.1 | 59.1 | 54.8 | 54.7 | 54.7 | 54.9 | 40.4 | 52.4 | 59.3 | - | - |
| | Alumina | - | - | - | - | - | - | - | - | - | - | - |
| (C) Carbon compound [mass%] | CNT | 0.4 | 0.4 | 0.2 | 0.3 | 0.4 | - | 0.2 | 0.2 | - | 0.3 | 0.3 |
| | CB | - | - | 7.5 | 7.5 | 7.5 | 7.5 | 7.9 | 7.2 | - | 9.1 | 9.1 |
| | Graphene | - | - | - | - | - | - | - | - | - | - | - |
| (D) Dispersion aid [mass%] | Cellulose nanofibers | - | - | - | - | - | - | - | - | - | - | - |
| | Coupling agent | - | - | - | - | - | - | - | - | - | - | - |
| (E) Magnetic body [mass%] | Fe-Si-Cr powder | - | - | - | - | - | - | - | - | - | - | - |
| Curing agent [mass%] | Curing agent 1 | 7.3 | 9.7 | 6.8 | 6.7 | 6.7 | 11.3 | 11.9 | 10.8 | 7.3 | 13.6 | 8.2 |
| Curing accelerator [mass%] | Curing accelerator 1 | 4 | 4 | 3.8 | 3.7 | 3.7 | 3.8 | 4 | 3.6 | 4.1 | 4.5 | 4.5 |
| | Curing accelerator 2 | - | - | - | - | - | - | - | 0.1 | - | - | - |
| Volume resistivity ($\rho v$) | [Qcm] | $8.0 \times 10^8$ | $1.0 \times 10^9$ | $5.0 \times 10^9$ | $5.0 \times 10^7$ | $1.0 \times 10^7$ | $8.0 \times 10^9$ | $6.0 \times 10^{10}$ | $7.0 \times 10^9$ | $1.0 \times 10^9$ | $8.0 \times 10^8$ | $8.5 \times 10^8$ |

(continued)

| | | Examples | | | | | | | | | | |
|---|---|---|---|---|---|---|---|---|---|---|---|---|
| | | 1 | 2 | 3 | 4 | 5 | 6 | 7 | 8 | 9 | 10 | 11 |
| Real part (ε') of complex dielectric constant | [-] | 19.02 | 18.20 | 18.78 | 21.71 | 20.93 | 16.30 | 15.00 | 18.70 | 12.61 | 9.80 | 9.50 |
| Imaginary part (ε") of complex dielectric constant | [-] | 5.62 | 6.24 | 4.96 | 7.68 | 6.93 | 4.10 | 4.07 | 4.50 | 4.05 | 4.00 | 4.50 |
| Dielectric Loss tangent (tanδ) | [-] | 0.30 | 0.34 | 0.26 | 0.35 | 0.33 | 0.25 | 0.27 | 0.24 | 0.32 | 0.41 | 0.47 |
| logρv[-] | [-] | 8.9 | 9.0 | 9.7 | 7.7 | 7.0 | 9.9 | 10.8 | 9.9 | 9.0 | 8.9 | 8.9 |
| (logρv) × ε" | [-] | 50.0 | 56.1 | 48.1 | 59.1 | 48.5 | 40.6 | 43.9 | 44.3 | 36.5 | 35.6 | 40.2 |
| Coefficient of thermal conductivity | [W/mK] | 1.1 | 1.1 | 1.4 | 1.4 | 1.4 | 1.3 | 1.2 | 1.3 | 0.9 | 0.8 | 0.8 |
| Specific gravity | [-] | 2.0 | 2.0 | 1.9 | 1.9 | 1.9 | 1.9 | 1.8 | 1.8 | 2.0 | 1.5 | 1.5 |
| Thermal expansion coefficient α1 | [ppm/deg.] | 35 | 35 | 38 | 38 | 38 | 38 | 30 | 35 | 34 | 40 | 40 |
| Electromagnetic wave-absorption performance | [dB] | -10.6 | -10.8 | -12.5 | -13.7 | -16.7 | -10.1 | -11.1 | -11.8 | -6.0 | -8.8 | -9.8 |

[Table 1-2]

Table 1-2

| | | Examples | | | | | | | | | | |
|---|---|---|---|---|---|---|---|---|---|---|---|---|
| | | 12 | 13 | 14 | 15 | 16 | 17 | 18 | 19 | 20 | 21 | 22 |
| (A) Resin [mass%] | Epoxy resin 1 | 27.2 | 27.0 | 27.0 | - | - | 10.2 | 10.2 | 7.8 | 12.5 | 5.7 | 6.0 |
| | Epoxy resin 2 | - | - | - | 26.5 | 26.5 | - | - | 2.6 | - | 1.9 | 2.0 |
| | Epoxy resin 3 | - | - | - | - | - | 3.4 | 3.4 | - | - | - | - |
| | Maleimide resin 1 | - | - | - | - | - | - | - | - | - | - | - |
| (B) Inorganic filler [mass%] | Silica | 45.3 | 44.9 | 44.9 | - | - | 79.0 | 79.0 | 84.0 | 79.0 | 5.0 | - |
| | SiC | - | - | - | 54.4 | 54.4 | - | - | - | - | - | 4.0 |
| | Alumina | - | - | - | - | - | - | - | - | - | 84.0 | 84.0 |
| (C) Carbon compound [mass%] | CNT | - | 0.3 | 0.3 | 0.2 | 0.2 | 0.3 | - | 0.3 | 0.3 | 0.3 | 0.3 |
| | CB | 9.1 | 9.0 | 9.0 | - | 7.4 | - | - | - | - | - | - |
| | Graphene | 0.3 | - | - | 7.4 | - | - | 0.3 | - | - | - | - |
| (D) Dispersion aid [mass%] | Cellulose nanofibers | - | 0.9 | - | 0.9 | - | - | - | - | 0.9 | - | - |
| | Coupling agent | - | - | 0.9 | - | 0.9 | - | - | - | - | - | - |
| (E) Magnetic body [mass%] | Fe-Si-Cr powder | - | - | - | - | - | - | - | - | - | - | - |
| Curing agent [mass%] | Curing agent 1 | 13.6 | 13.5 | 13.5 | 7.0 | 7.0 | 6.1 | 6.1 | 4.6 | 6.2 | 3.4 | 3.5 |
| Curing accelerator [mass%] | Curing accelerator 1 | 4.5 | 4.5 | 4.5 | 3.7 | 3.7 | 1.0 | 1.0 | 0.7 | 1.0 | 0.2 | 0.2 |
| | Curing accelerator 2 | - | - | - | - | - | - | - | - | - | - | - |
| Volume resistivity (ρv) | [Qcm] | $1.0 \times 10^9$ | $5.0 \times 10^{10}$ | $3.0 \times 10^{11}$ | $8.0 \times 10^9$ | $3.0 \times 10^9$ | $1.0 \times 10^9$ | $5.0 \times 10^9$ | $5.0 \times 10^9$ | $1.0 \times 10^9$ | $6.0 \times 10^9$ | $1.0 \times 10^9$ |
| Real part (ε') of complex dielectric constant | [-] | 9.00 | 9.20 | 9.20 | 15.30 | 18.20 | 9.20 | 7.50 | 9.00 | 8.50 | 12.50 | 12.00 |

(continued)

| | | Examples | | | | | | | | | | |
|---|---|---|---|---|---|---|---|---|---|---|---|---|
| | | 12 | 13 | 14 | 15 | 16 | 17 | 18 | 19 | 20 | 21 | 22 |
| Imaginary part (ε") of complex dielectric constant | [-] | 4.20 | 5.00 | 5.50 | 4.30 | 4.50 | 6.20 | 4.00 | 6.10 | 6.10 | 5.20 | 6.20 |
| Dielectric Loss tangent (tanδ) | [-] | 0.47 | 0.54 | 0.60 | 0.28 | 0.25 | 0.67 | 0.53 | 0.67 | 0.72 | 0.42 | 0.52 |
| logρv[-] | [-] | 9.0 | 10.7 | 11.5 | 9.9 | 9.5 | 9.0 | 9.7 | 9.7 | 9.0 | 9.8 | 9.0 |
| (logρv) × ε" | [-] | 37.8 | 53.5 | 63.1 | 42.6 | 42.8 | 55.8 | 38.8 | 59.2 | 54.9 | 51.0 | 55.8 |
| Coefficient of thermal conductivity | [W/mK] | 0.8 | 0.9 | 0.9 | 1.5 | 1.4 | 0.8 | 0.8 | 1.0 | 0.8 | 4.2 | 4.8 |
| Specific gravity | [-] | 1.5 | 1.5 | 1.5 | 1.9 | 1.9 | 1.9 | 1.9 | 1.9 | 1.9 | 2.9 | 2.9 |
| Thermal expansion coefficient α1 | [ppm/deg.] | 40 | 40 | 40 | 35 | 37 | 13 | 13 | 10 | 12 | 13 | 13 |
| Electromagnetic wave-absorption performance | [dB] | -10.0 | -11.5 | -12.4 | -12.6 | -13.1 | -14.5 | -11.1 | -13.7 | -15.0 | -12.2 | -13.5 |

[Table 2]

Table 2

| | | Comparative Examples | | | | | |
|---|---|---|---|---|---|---|---|
| | | 1 | 2 | 3 | 4 | 5 | 6 |
| (A) Resin [mass%] | Epoxy resin 1 | - | 29.9 | 24.4 | 28.6 | - | - |
| | Epoxy resin 2 | 36 | - | - | - | 36 | 16.5 |
| | Epoxy resin 3 | - | - | - | - | - | - |
| | Maleimide resin 1 | - | - | - | - | - | - |
| (B) Inorganic filler [mass%] | Silica | 50 | 50 | - | 47.6 | 50 | - |
| | SiC | - | - | 59.3 | - | - | - |
| (C) Carbon compound [mass%] | CNT | - | 0.5 | - | - | 0.1 | - |
| | CB | - | - | - | - | - | - |
| | Graphene | - | - | - | - | - | - |
| (D) Dispersion aid [mass%] | Cellulose nanofibers | - | - | - | - | - | - |
| | Coupling agent | - | - | - | - | - | - |
| (E) Magnetic body [mass%] | Fe-Si-Cr powder | - | - | - | - | - | 77 |
| Curing agent [mass%] | Curing agent 1 | 9 | 14.9 | 12.2 | 14.3 | 9 | 4 |
| Curing accelerator [mass%] | Curing accelerator 1 | 5 | 5 | 4.1 | 9.5 | 5 | 2.5 |
| | Curing accelerator 2 | - | - | - | - | - | - |
| Volume resistivity ($\rho v$) | [Qcm] | $1.0 \times 10^{13}$ | $1.0 \times 10^{3}$ | $5.0 \times 10^{8}$ | $10 \times 10^{13}$ | $1.0 \times 10^{9}$ | $1.0 \times 10^{8}$ |
| Real part ($\varepsilon$') of complex dielectric constant | [-] | 2.69 | 7.00 | 11.00 | 3.70 | 5.00 | 25.00 |
| Imaginary part ($\varepsilon$") of complex dielectric constant | [-] | 0.20 | 2.00 | 2.30 | 0.04 | 1.00 | 0.20 |
| Dielectric Loss tangent ($\tan\delta$) | [-] | 0.07 | 0.29 | 0.21 | 0.01 | 0.20 | 0.01 |
| $\log\rho v$ | [-] | 13.0 | 3.0 | 8.7 | 13.0 | 9.0 | 8.0 |
| ($\log\rho v$) $\times$ $\varepsilon$" | [-] | 2.6 | 6.0 | 20.0 | 0.5 | 9.0 | 1.6 |
| Coefficient of thermal conductivity | [W/mK] | 0.5 | 0.6 | 0.9 | 0.5 | 0.5 | 1.0 |
| Specific gravity | [-] | 1.6 | 1.8 | 2.0 | 1.6 | 1.6 | 3.4 |
| Thermal expansion coefficient $\alpha 1$ | [ppm/deg.] | 38 | 38 | 34 | 40 | 36 | 40 |
| Electromagnetic wave-absorption performance | [dB] | -1.0 | -2.5 | -2.8 | 0.0 | -2.3 | -2.0 |

It is clear that the molded bodies of the resin compositions satisfying the relational expression (1) and having an imaginary part ($\varepsilon$") greater than 1.25 exhibit superior electromagnetic wave-absorption performance in the high

frequency band.

REFERENCE SIGNS

10 Electronic component
1 Lead frame
2 Semiconductor element
3 Adhesive layer
4 Electrode
5 Lead part
6 Bonding wire
7 Molded body (sealing material) of resin composition

## Claims

1. A resin composition, a molded body of which is an electromagnetic wave absorber,

   an imaginary part (ε") of a complex dielectric constant of the molded body at 25°C and 10 GHz and a volume resistivity (ρv) at 25°C of the molded body satisfying a relational expression (1) below, and
   the imaginary part (ε") being greater than 1.25.

$$20 < (\log\rho v) \times \varepsilon'' < 600 \quad (1)$$

2. The resin composition according to claim 1, wherein a real part (ε') of the complex dielectric constant at 25°C and 10 GHz of the molded body is less than 40.

3. The resin composition according to claim 1 or 2, wherein a thermal expansion coefficient of the molded body is from 1 to 40 ppm/deg.

4. The resin composition according to any one of claims 1 to 3, wherein the resin composition comprises:

   (A) at least one resin selected from the group consisting of thermosetting resins and thermoplastic resins;
   (B) an inorganic filler (excluding a component (C)); and
   (C) a carbon material.

5. The resin composition according to claim 4, wherein the component (A) is an epoxy resin.

6. The resin composition according to claim 5, wherein the epoxy resin comprises a polyoxyalkylene structure.

7. The resin composition according to any one of claims 4 to 6, wherein the component (B) is silicon carbide.

8. The resin composition according to any one of claims 4 to 7, wherein the component (C) is at least one selected from the group consisting of carbon nanotubes and graphene.

9. An electronic component comprising a molded body of the resin composition described in any one of claims 1 to 8.

[Fig. 1]

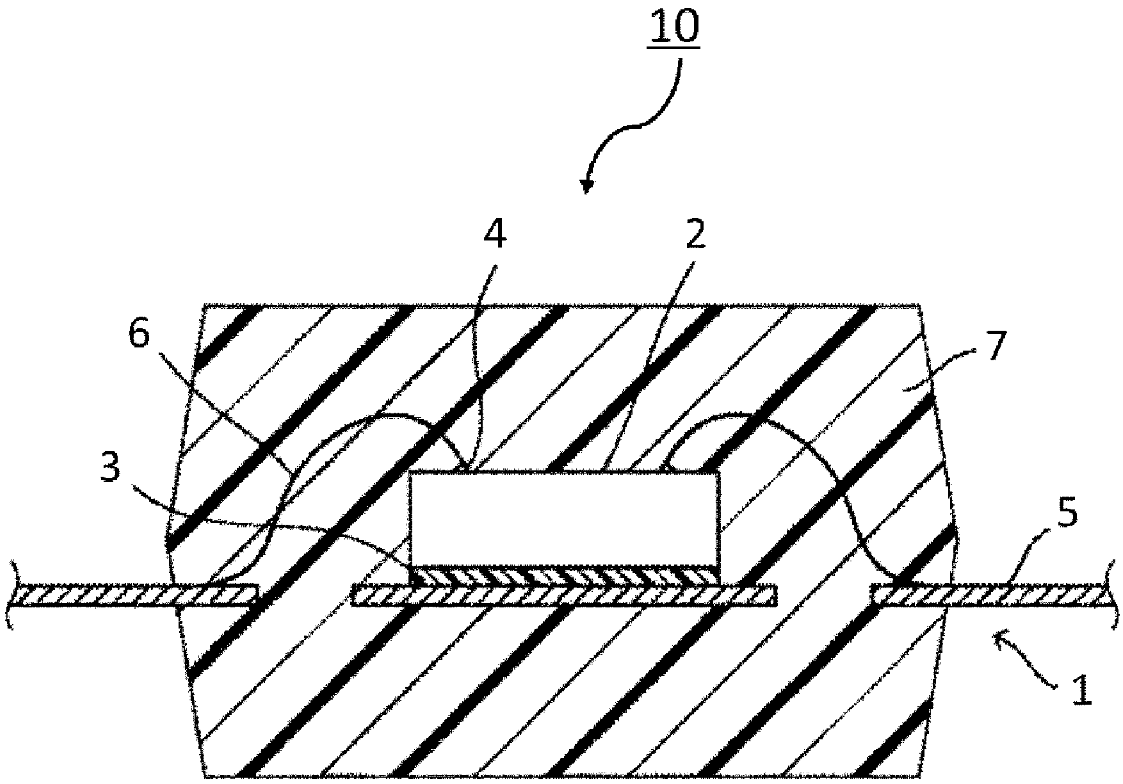


FIG. 1

**INTERNATIONAL SEARCH REPORT**

International application No. PCT/JP2021/019714

A. CLASSIFICATION OF SUBJECT MATTER

C08L 101/00(2006.01)i; C08L 63/00(2006.01)i; C08K 3/00(2018.01)i; C08K 3/04(2006.01)i; C08K 3/34(2006.01)i; H05K 9/00(2006.01)i
FI: C08L101/00 ZNM; C08K3/00; C08K3/34; C08L63/00 C; C08K3/04; H05K9/00 X

According to International Patent Classification (IPC) or to both national classification and IPC

B. FIELDS SEARCHED

Minimum documentation searched (classification system followed by classification symbols)
C08L101/00; C08L63/00; C08K3/00; C08K3/04; C08K3/34; H05K9/00

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2008-1757 A (KYOCERA CHEMICAL CORP.) 10 January 2008 (2008-01-10) claims, examples | 1-5, 9<br>6-8 |
| X<br>A | JP 2011-144235 A (SUMITOMO BAKELITE CO., LTD.) 28 July 2011 (2011-07-28) claims, examples | 1-5, 9<br>6-8 |
| P, X<br>P, A | JP 2020-145270 A (SUMITOMO BAKELITE CO., LTD.) 10 September 2020 (2020-09-10) claims, examples | 1-5, 9<br>6-8 |
| P, X<br>P, A | JP 2020-111748 A (KYOCERA CORP.) 27 July 2020 (2020-07-27) claims, examples | 1-5, 9<br>6-8 |
| A | JP 2019-210447 A (SUMITOMO BAKELITE CO., LTD.) 12 December 2019 (2019-12-12) entire text | 1-9 |

☐ Further documents are listed in the continuation of Box C.　　☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 05 July 2021 (05.07.2021) | 20 July 2021 (20.07.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2021/019714

| Patent Documents referred in the Report | Publication Date | Patent Family | Publication Date |
|---|---|---|---|
| JP 2008-1757 A | 10 Jan. 2008 | (Family: none) | |
| JP 2011-144235 A | 28 Jul. 2011 | (Family: none) | |
| JP 2020-145270 A | 10 Sep. 2020 | (Family: none) | |
| JP 2020-111748 A | 27 Jul. 2020 | (Family: none) | |
| JP 2019-210447 A | 12 Dec. 2019 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001068889 A
- JP 2005057093 A
- JP 2012209515 A


### Non-patent literature cited in the description


- *IEICE Transactions on Fundamentals of Electronics, Communications, and Computer Sciences B,* vol. J97-B (3), 279-285